# EUROPEAN PATENT APPLICATION

(11) **EP 4 699 936 A2**
(43) Date of publication of application: **25.02.2026**
(21) Application number: 25196829.3
(22) Date of filing: 19.08.2025
(51) Int. Cl.: B64D 27/33, B64D 27/34, B64D 27/357, B64D 31/16, B64D 31/18, B64D 35/022, B64D 35/026

(54) **MEASURING EFFICIENCY IN AN ELECTRIC POWER SYSTEM FOR AN AIRCRAFT PROPULSION SYSTEM**

(30) Priority: 19.08.2024 US 202418809167
(71) Applicant: PRATT & WHITNEY CANADA CORP., Longueuil, Québec J4G 1A1 (CA)
(72) Inventor: SHENOUDA, Antwan, (01BE5) Longueuil, J4G 1A1 (CA); JARVO, James, (01BE5) Longueuil, J4G 1A1 (CA); ROBACHE, Remi, (01BE5) Longueuil, J4G 1A1 (CA)
(74) Representative: Dehns

(57) **Abstract**

An assembly for an aircraft includes a power system (24) and a monitoring system (26). The power system (24) includes an electric power source (30), an electric motor (34) and a motor controller (32) electrically coupled between the electric power source (30) and the electric motor (34). The motor controller (32) is configured to regulate a flow of electricity from the electric power source (30) to the electric motor (34). The electric motor (34) is configured to drive rotation of a rotating component (76). The monitoring system (26) is configured to determine an electric power output parameter, a mechanical power output parameter and an efficiency parameter based on the electric power output parameter and the mechanical power output parameter. The electric power output parameter is indicative of an electric power drawn by the electric motor (34) through the motor controller (32) from the electric power source (30). The mechanical power output parameter is indicative of a mechanical power received by the rotating component (76) from the electric motor (34).

## Description

### TECHNICAL FIELD

This disclosure relates generally to an aircraft propulsion system and, more particularly, to an electric power system for the aircraft propulsion system.

### BACKGROUND INFORMATION

An aircraft propulsion system may include an electric power system with an electric motor for driving rotation of a bladed rotor such as a propeller. Various systems and methods are known in the art for monitoring operation of the electric power system. While these known systems and methods have various benefits, there is still room in the art for improvement.

### SUMMARY

According to an aspect of the present disclosure, an assembly is provided for an aircraft. This assembly includes a power system and a monitoring system. The power system includes an electric power source, an electric motor and a motor controller electrically coupled between the electric power source and the electric motor. The motor controller is configured to regulate a flow of electricity from the electric power source to the electric motor. The electric motor is configured to drive rotation of a rotating component. The monitoring system is configured to determine an electric power output parameter, a mechanical power output parameter and an efficiency parameter based on the electric power output parameter and the mechanical power output parameter. The electric power output parameter is indicative of an electric power drawn by the electric motor through the motor controller from the electric power source. The mechanical power output parameter is indicative of a mechanical power received by the rotating component from the electric motor.

According to another aspect of the present disclosure, another assembly is provided for an aircraft. This assembly includes a propulsor rotor, a power system and a monitoring system. The power system includes an electric power source, an electric motor, a power distribution system and a motor controller. The electric motor is configured to drive rotation of the propulsor rotor. The power distribution system electrically couples the electric power source to the motor controller. The motor controller is electrically coupled between the power distribution system and the electric motor. The motor controller is configured to regulate a flow of electricity from the electric power source, through the power distribution system, to the electric motor. The monitoring system is configured to determine an electric power output parameter, a distribution system electric power parameter and an efficiency parameter based on the electric power output parameter and the distribution system electric power parameter. The electric power output parameter is indicative of an electric power drawn by the electric motor through the motor controller and the power distribution system from the electric power source. The distribution system electric power parameter is indicative of an electric power input into or output from the power distribution system.

According to still another aspect of the present disclosure, another assembly is provided for an aircraft. This assembly includes a propulsor rotor, a power system and a monitoring system. The power system includes an electric power source, an electric motor, a power distribution system and a motor controller. The electric motor is configured to drive rotation of the propulsor rotor. The power distribution system electrically couples the electric power source to the motor controller. The motor controller is electrically coupled between the power distribution system and the electric motor. The motor controller is configured to regulate a flow of electricity from the electric power source, through the power distribution system, to the electric motor. The monitoring system is configured to determine a distribution system electric power parameter, a controller electric power parameter and an efficiency parameter based on the distribution system electric power parameter and the controller electric power parameter. The distribution system electric power parameter is indicative of an electric power input into or output from the power distribution system. The controller electric power parameter is indicative of an electric power input into or output from the motor controller.

The following optional features may be applied to any of the above aspects.

The monitoring system may include a voltage sensor, a current sensor and a system controller. The voltage sensor may be configured to determine a voltage drawn by the electric motor through the motor controller from the electric power source. The current sensor may be configured to determine a current drawn by the electric motor through the motor controller from the electric power source. The system controller may be configured to determine the electric power output parameter based on the voltage and the current.

The monitoring system may include a speed sensor, a torque sensor and a system controller. The speed sensor may be configured to determine a speed that the rotating component rotates about an axis. The torque sensor may be configured to determine a torque received by the rotating component from the electric motor. The system controller may be configured to determine the mechanical power output parameter based on the speed and the torque.

The monitoring system may include a system controller configured to control operation of the motor controller to regulate the flow of electricity from the electric power source to the electric motor.

The efficiency parameter may be determined by comparing the electric power output parameter and the mechanical power output parameter.

The monitoring system may also be configured to compare the efficiency parameter to a threshold to determine presence of a fault in the power system.

The fault may be determined as being present when the efficiency parameter is below the threshold.

The fault may be indicative of a failure in the electric motor.

The fault may be indicative of a failure in the motor controller.

The fault may be indicative of a failure in the power system upstream of the motor controller.

The threshold may be determined using artificial intelligence.

The monitoring system may also be configured to compare the efficiency parameter to a threshold to predict a future fault in the power system.

The monitoring system may also be configured to determine a controller electric power parameter and a second efficiency parameter. The controller electric power parameter may be indicative of an electric power input into or output from the motor controller. The second efficiency parameter may be determined based on the controller electric power parameter and one of the electric power output parameter or the mechanical power output parameter.

The second efficiency parameter may be determined based on the controller electric power parameter and the electric power output parameter. The monitoring system may also be configured to compare the second efficiency parameter to a threshold to determine presence of a fault in the power system upstream of the electric motor.

The second efficiency parameter may be determined based on the controller electric power parameter and the mechanical power output parameter. The monitoring system may also be configured to compare the second efficiency parameter to a threshold to determine presence of a fault in the power system downstream of the electric power source.

The power system may also include a power distribution system electrically coupling the electric power source to the motor controller. The monitoring system may also be configured to determine a distribution system electric power parameter and a second efficiency parameter. The distribution system electric power parameter may be indicative of an electric power input into or output from the power distribution system. The second efficiency parameter may be determined based on the distribution system electric power parameter and the electric power output parameter.

The monitoring system may also be configured to compare the second efficiency parameter to a threshold to determine presence of a fault in the power system upstream of the motor controller.

The power system may also include a power distribution system electrically coupling the electric power source to the motor controller. The monitoring system may also be configured to determine a controller electric power parameter, a distribution system electric power parameter and a second efficiency parameter. The controller electric power parameter may be indicative of an electric power input into or output from the motor controller. The distribution system electric power parameter may be indicative of an electric power input into or output from the power distribution system. The second efficiency parameter may be determined based on the controller electric power parameter and the distribution system electric power parameter.

The monitoring system may also be configured to compare the second efficiency parameter to a threshold to determine presence of a fault in the power system downstream of the electric power source and upstream of the electric motor.

The electric power source may include at least one of: one or more battery cells; or one or more fuel cells.

The rotating component may be configured as or otherwise include an output shaft of the electric motor.

The assembly may also include a gear system coupled between an output shaft of the electric motor and the rotating component.

The assembly may also include a geartrain including the gear system and an output shaft of the geartrain. The rotating component may be configured as or otherwise include the output shaft of the geartrain.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a schematic illustration of an aircraft propulsion system including a propulsor rotor, an electric power system and a monitoring system.
FIGS. 2A-C are schematic illustrations of various electric power sources for the electric power system.
FIG. 3 is a flow diagram of a method for operating an aircraft propulsion system.
FIG. 4 is a partial schematic illustration of the aircraft propulsion system further including a power distribution system.
FIG. 5A is a partial schematic illustration of the aircraft propulsion system configured as an electric propulsion system.
FIG. 5B is a partial schematic illustration of the aircraft propulsion system configured as a hybrid propulsion system.

### DETAILED DESCRIPTION

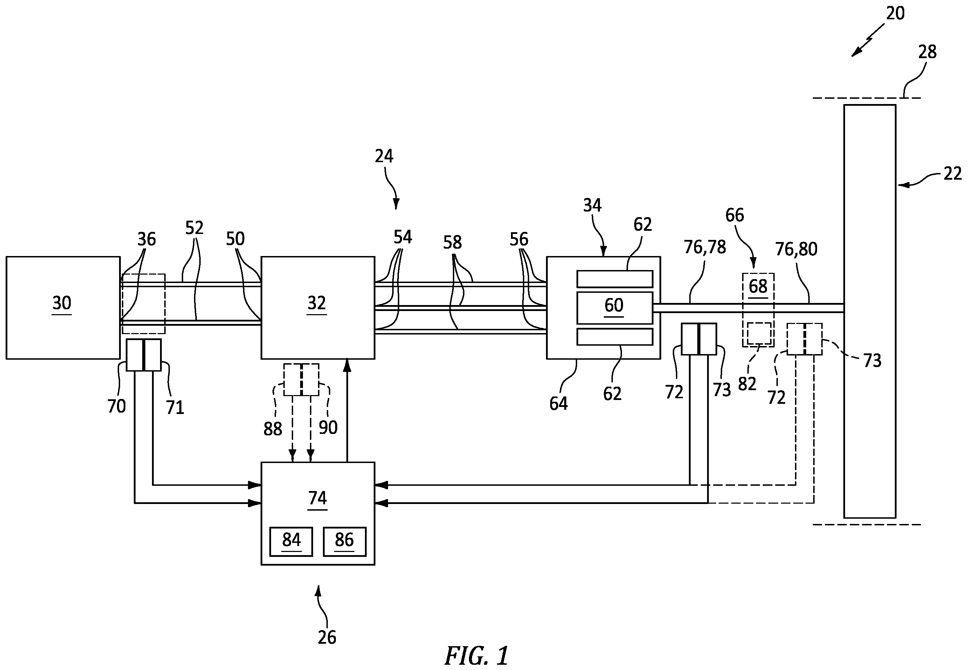

FIG. 1 illustrates a propulsion system 20 for an aircraft. The aircraft may be an airplane, a helicopter, a drone (e.g., an unmanned aerial vehicle (UAV)) or any other manned or unmanned aerial vehicle or system. The aircraft propulsion system 20 includes a bladed propulsor rotor 22, an electric power system 24 and a monitoring system 26.

The propulsor rotor 22 is rotatable about a rotational axis; e.g., a centerline axis of the propulsor rotor 22. The propulsor rotor 22 may be a ducted propulsor rotor, an open propulsor rotor (e.g., an un-ducted propulsor rotor) or any other type of bladed rotating air mover. The propulsor rotor 22, for example, may be disposed within a duct 28, where a wall of the duct 28 is radially outboard of, next to and circumscribes the propulsor rotor 22. An example of such a ducted propulsor rotor is a fan rotor. In another example, at least blades of the propulsor rotor 22 may be disposed in an ambient environment outside of the aircraft propulsion system 20. An example of such an open propulsor rotor is a propeller rotor. Another example of the open propulsor rotor is a rotorcraft rotor such as a main rotor of a helicopter, a tail rotor of the helicopter, etc. The present disclosure, however, is not limited to the foregoing exemplary propulsor rotor types or configurations.

The power system 24 is operatively coupled to and configured to drive rotation of the propulsor rotor 22 about its rotational axis. The power system 24 of FIG. 1 includes an electric power source 30, a motor controller 32 and an electric motor 34.

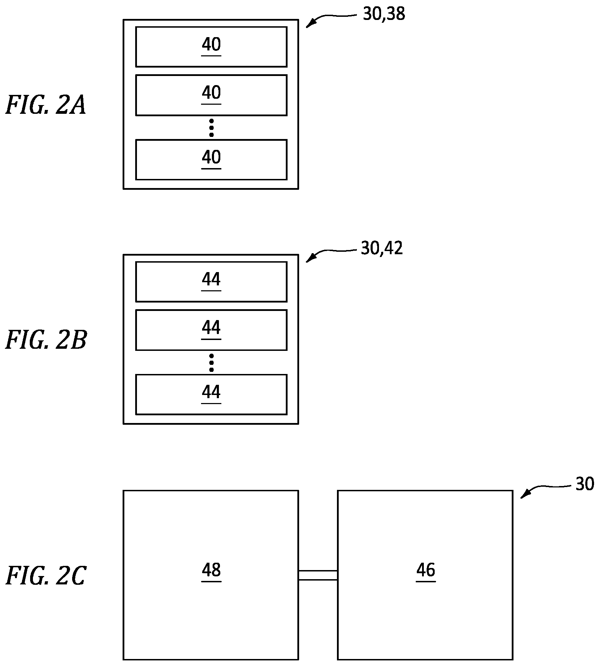

The electric power source 30 is configured to store and/or generate electricity. The electric power source 30 is also configured to output the electricity from one or more electrical outputs 36 of the electric power source 30; e.g., outlet terminals. For example, referring to FIG. 2A, the electric power source 30 may be configured as or otherwise include a battery system 38 with one or more energy storage units 40; e.g., battery cells, supercapacitors, etc. Referring to FIG. 2B, the electric power source 30 may also or alternatively be configured as or otherwise include a fuel cell system 42 with one or more fuel cells 44. Referring to FIG. 2C, the electric power source 30 may still also or alternatively be configured as or otherwise include an electric generator 46 mechanically powered by a heat engine 48. Examples of the heat engine 48 include, but are not limited to, a gas turbine engine, a reciprocating piston engine, a rotary engine (e.g., a Wankel engine), or another type of continuous or intermittent internal combustion engine. Of course, it is contemplated the electric power source 30 may include two or more of the power sources of FIGS. 2A-C.

Referring to FIG. 1, the motor controller 32 is electrically coupled between the electric power source 30 and the electric motor 34. The motor controller 32 of FIG. 1, for example, includes one or more electrical inputs 50 into the motor controller 32; e.g., input terminals. Each of these controller inputs 50 is electrically coupled to a respective one of the power source outputs 36 through, for example, at least (or only) an electric power cable 52. The motor controller 32 of FIG. 1 also include one or more electrical outputs 54 from the motor controller 32; e.g., output terminals. Each of these controller outputs 54 is electrically coupled to a respective electrical input 56 into the electric motor 34 through, for example, at least (or only) an electric power cable 58.

The motor controller 32 is configured to regulate a flow of electricity drawn from the electric power source 30 and directed to the electric motor 34. In one mode, the motor controller 32 may cut off the flow of electricity drawn from the electric power source 30 and directed to the electric motor 34. The motor controller 32, for example, may electrically decouple the electric power source 30 from the electric motor 34. In another mode, the motor controller 32 may open up the flow of electricity drawn from the electric power source 30 and directed to the electric motor 34. The motor controller 32, for example, may electrically couple the electric power source 30 to the electric motor 34. Here, the motor controller 32 may selectively regulate a rate of the electricity being drawn from the electric power source 30 and directed to the electric motor 34 to an intermediate level or a full (e.g., maximum) level. The motor controller 32 may be implemented using one or more electric elements. Examples of these electric elements include, but are not limited to, switches, contactors, relays, current regulators, amplifiers, capacitors, resistors, etc.

The electric motor 34 includes an electric motor rotor 60, an electric motor stator 62 and an electric motor housing 64. The motor rotor 60 is rotatable about a rotational axis of the motor rotor 60; e.g., a centerline axis of the electric motor 34 and its members 60, 62 and/or 64. The motor stator 62 of FIG. 1 is radially outboard of and circumscribes the motor rotor 60. With this arrangement, the electric motor 34 is configured as a radial flux electric motor. The electric motor 34 of the present disclosure, however, is not limited to such an exemplary rotor-stator configuration nor to radial flux arrangements. The motor rotor 60, for example, may alternatively be radially outboard of and circumscribe the motor stator 62. In another example, the motor rotor 60 may be axially next to the motor stator 62 configuring the electric motor 34 as an axial flux electric motor. Referring again to FIG. 1, the motor rotor 60 and the motor stator 62 are at least partially or completely housed within the motor housing 64.

The motor rotor 60 is coupled to the propulsor rotor 22 through a drivetrain 66. This drivetrain 66 may be configured as a geared drivetrain, where a geartrain 68 (e.g., a transmission, a speed change device, an epicyclic geartrain, etc.) is disposed between and operatively couples the propulsor rotor 22 to the electric motor 34 and its motor rotor 60. With this arrangement, the propulsor rotor 22 may rotate at a different (e.g., slower, or faster) rotational speed than the motor rotor 60. However, the drivetrain 66 may alternatively be configured as a direct drive drivetrain, where the geartrain 68 is omitted. With such an arrangement, the propulsor rotor 22 rotates at a common (the same) rotational speed as the motor rotor 60.

During power system operation, the motor controller 32 may electrically couple the electric motor 34 to the electric power source 30 such that the electric motor 34 draws electricity from the electric power source 30 through the motor controller 32 at a select rate. Briefly, this rate controls a power level of the electric motor 34. For example, where the motor controller 32 regulates the rate at the intermediate level, the electric motor 34 operates at an intermediate power level. Where the motor controller 32 regulates the rate at the full level, the electric motor 34 operates at a full (e.g., maximum) power level. Within the electric motor 34, the electricity received from the electric power source 30 through the motor controller 32 is used to generate an electromagnetic field between the motor stator 62 and the motor rotor 60. This electromagnetic field drives rotation of the motor rotor 60 about its rotational axis. The rotation of the motor rotor 60 drives rotation of the propulsor rotor 22 about its rotational axis through the drivetrain 66. The rotation of the propulsor rotor 22 propels air, for example, to generate aircraft thrust and/or lift.

For ease of description, the electric motor 34 is described herein as a dedicated electric motor. However, it is contemplated the electric motor 34 may alternatively be configured as part of an electric machine (e.g., a motor-generator) operable as both the electric motor 34 and an electric generator. For example, when operating as the electric generator, the electromagnetic field within the electric machine and the flow of electricity between the electric machine and the electric power source 30 may be reversed.

The monitoring system 26 is configured to monitor operation of the power system 24. The monitoring system 26 may also be configured as a control system that controls operation of the power system 24 and its motor controller 32. The monitoring system 26 of FIG. 1, for example, includes one or more sensors 70-73 and a system controller 74. The sensors of FIG. 1 include, but are not limited to, a power source voltage sensor 70, a power source current sensor 71, a speed sensor 72 and a torque sensor 73.

The power source voltage sensor 70 is arranged with the electric power source 30. The power source voltage sensor 70 is configured to determine (e.g., measure) a voltage drawn by the electric motor 34 through the motor controller 32 from the electric power source 30. The power source voltage sensor 70, for example, may determine a total voltage output from the power source outputs 36. Alternatively, the monitoring system 26 may include multiple power source voltage sensors, where each of these power source voltage sensors determines a voltage output from a respective one of the power source outputs 36.

The power source current sensor 71 is arranged with the electric power source 30. The power source current sensor 71 is configured to determine (e.g., measure) a current drawn by the electric motor 34 through the motor controller 32 from the electric power source 30. The power source current sensor 71, for example, may determine a total current output from the power source outputs 36. Alternatively, the monitoring system 26 may include multiple power source current sensors, where each of these power source current sensors determines a current output from a respective one of the power source outputs 36.

The speed sensor 72 is arranged with a rotating component 76; e.g., a rotating component of the drivetrain 66. For ease of description, this rotating component 76 is generally described below as an output shaft 78 of the electric motor 34; e.g., a shaft connected to the motor rotor 60. However, it is contemplated the rotating component 76 may alternatively be configured as an output shaft 80 of the geartrain 68, where an internal gear system 82 of the geartrain 68 couples the motor shaft 78 to the geartrain shaft 80. Still alternatively, it is contemplated the rotating component 76 may alternatively be configured as a shaft for the propulsor rotor 22, or alternatively the propulsor rotor 22 itself. The present disclosure, however, is not limited to the foregoing exemplary rotating components. Referring again to FIG. 1, the speed sensor 72 is configured to determine (e.g., measure) a rotational speed of the rotating component 76 about its rotational axis.

The torque sensor 73 is arranged with the rotating component 76, for example at a similar location as the speed sensor 72. The torque sensor 73 is configured to determine (e.g., measure) a rotational torque received by the rotating component 76 from the electric motor 34.

The system controller 74 is in signal communication (e.g., hardwired and/or wirelessly coupled) with each of the monitoring system sensors 70-73. The system controller 74 may also be in signal communication with the motor controller 32. The system controller 74 may be configured as an onboard controller for the aircraft propulsion system 20; e.g., an electronic engine controller (EEC), an electronic control unit (ECU), a full-authority digital engine controller (FADEC), etc. The system controller 74 may be implemented with a combination of hardware and software. The hardware may include memory 84 and at least one processing device 86, which processing device 86 may include one or more single-core and/or multi-core processors. The hardware may also or alternatively include analog and/or digital circuitry other than that described above.

The memory 84 is configured to store software (e.g., program instructions) for execution by the processing device 86, which software execution may control and/or facilitate performance of one or more operations such as those described below. The memory 84 may be a non-transitory computer readable medium. For example, the memory 84 may be configured as or include a volatile memory and/or a nonvolatile memory. Examples of a volatile memory may include a random access memory (RAM) such as a dynamic random access memory (DRAM), a static random access memory (SRAM), a synchronous dynamic random access memory (SDRAM), a video random access memory (VRAM), etc. Examples of a nonvolatile memory may include a read only memory (ROM), an electrically erasable programmable read-only memory (EEPROM), a computer hard drive, etc.

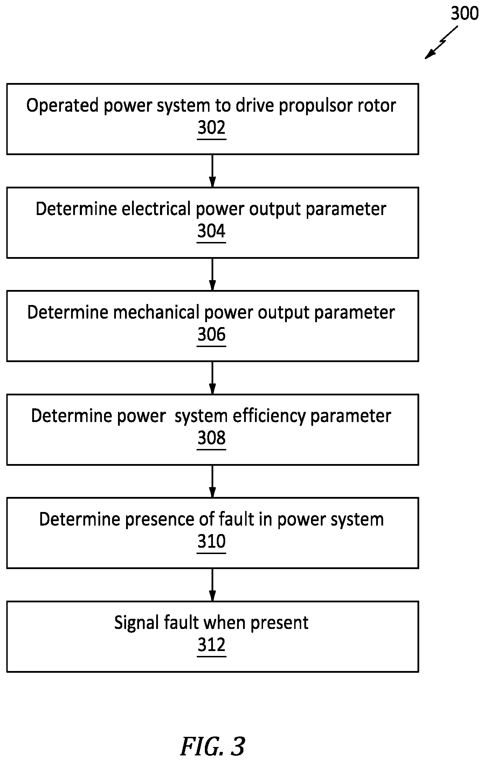

FIG. 3 is a flow diagram of a method 300 for operating an aircraft propulsion system. For ease of description, the operating method 300 is described below with reference to the aircraft propulsion system 20 of FIG. 1. The operating method 300 of the present disclosure, however, is not limited to such an exemplary aircraft propulsion system.

In step 302, the power system 24 is operated to electrically power operation of the electric motor 34. This operation of the electric motor 34 drives rotation of the propulsor rotor 22 as described above.

In step 304, the monitoring system 26 determines an electrical power output parameter. This electrical power output parameter is indicative of an electric power drawn by the electric motor 34, through the motor controller 32, from the electric power source 30. The electrical power output parameter is thereby indicative of the total electrical power output from the electric power source 30 at its power source outputs 36 for the electric motor 34. The system controller 74, for example, may receive a voltage signal from the power source voltage sensor 70 and a current signal from the power source current sensor 71. The voltage signal is indicative of the voltage determined by the power source voltage sensor 70. The current signal is indicative of the current determined by the power source current sensor 71. The system controller 74 may then process data from the voltage signal with data from the power source current sensor 71 to determine the electrical power output parameter. More particularly, the system controller 74 may multiply the determined voltage (V) by the determined current (i) to determine the total electrical power output (Pₑ) from the electric power source 30 at its power source outputs 36; e.g., Pₑ = V * i.

In step 306, the monitoring system 26 determines a mechanical power output parameter. This mechanical power output parameter is indicative of a mechanical power received by the rotating component 76 from the electric motor 34. The mechanical power output parameter is thereby indicative of the mechanical power output from the electric motor 34 and applied to the rotating component 76 for mechanically rotating the rotating component 76 about its rotational axis. The system controller 74, for example, may receive a speed signal from the speed sensor 72 and a torque signal from the torque sensor 73. The speed signal is indicative of the speed determined by the speed sensor 72. The torque signal is indicative of the torque determined by the torque sensor 73. The system controller 74 may then process data from the speed signal with data from the torque signal to determine the mechanical power output parameter. More particularly, the system controller 74 may multiply the determined speed (n) by the determined torque (M) to determine the mechanical power (Pₘ) applied to the rotating component 76 by the electric motor 34; e.g., Pₘ = n * M.

While the monitoring system 26 is described above as using the speed signal received from the speed sensor 72 and the torque signal received from the torque sensor 73 to determine the mechanical power output parameter, the operating method 300 of the present disclosure is not limited thereto. It is contemplated, for example, the speed and/or the torque may be determined based respectively on a speed and/or a torque measured elsewhere in the aircraft propulsion system 20, for example where there is a known (e.g., fixed, or predictable) relationship between the measured speed and/or torque and the speed and/or torque at the rotating component 76. For example, the speed and the torque at the rotating component 76 may be calculated based on a measured speed and torque at the propulsor rotor 22. Moreover, it is contemplated the monitoring system 26 and its system controller 74 may determine the torque from one or more other measured operational parameters rather that, for example, directly measuring the torque.

While the step 306 is described following the step 304, it is contemplated these steps are performed simultaneously. Thus, the electrical power output parameter and the mechanical power output parameter may be determined for a common (e.g., the same) point in time. Of course, it is contemplated these parameters may alternatively be determined one after the other in a relatively short time period, or measurements used to determine the parameters may temporally overlap.

In step 308, the monitoring system 26 determines a power system efficiency parameter. This power system efficiency parameter is indicative of an efficiency of the power system 24 in transmitting power from the electric power source 30 to the rotating component 76. The power system efficiency parameter is determined based on the electrical power output parameter and the mechanical power output parameter, where the electrical power output parameter is compared to the mechanical power output parameter. The system controller 74, for example, may divide the mechanical power output parameter by the electrical power output parameter to determine the power system efficiency parameter. More particularly, the mechanical power (Pₘ) applied to the rotating component 76 by the electric motor 34 is divided by the total electrical power output (Pₑ) from the electric power source 30 at its power source outputs 36 to determine a power system efficiency (Eff); e.g., Eff = Pₘ / Pₑ.

In step 310, the monitoring system 26 may determine presence of a fault in the power system 24. The system controller 74, for example, may compare the power system efficiency parameter to a threshold; e.g., a threshold efficiency parameter. Where the power system efficiency parameter is equal to or above the threshold, the system controller 74 may determine there is no fault in the power system 24. However, where the power system efficiency parameter is less than the threshold, the system controller 74 may determine there is a fault present in the power system 24. Note, the mechanical power output parameter is expected to be less than the electrical power output parameter due to expected power system losses. The threshold may thereby be selected to account for such expected power system losses as well as, for example, an expected degradation of efficiency over time. In addition, it is contemplated the threshold may change based on one or more operating parameters. Examples of these operating parameters include, but are not limited to, a propulsion system power setting, an aircraft flight mode, environmental operating conditions, etc. Herein, the aircraft flight mode may describe a mode associated with whether the aircraft is taxiing, taking off, climbing, cruising, descending, landing, etc. The expected power transfer efficiency for the power system 24 may change based on any one or more of the foregoing operating parameters.

The system controller 74 may retrieve the threshold from a lookup table. Alternatively, the threshold may be determined using a computer model run by the system controller 74 and/or another device. It is contemplated this model may use artificial intelligence such as machine learning to determine the threshold. The present disclosure, however, is not limited to the foregoing exemplary threshold retrieval / determination techniques. For example, in still other embodiments, the system controller 74 may retrieve the threshold from the lookup table, and the lookup table may be populated with thresholds determined using artificial intelligence.

The fault determined (if present) in the step 310 may be indicative of a failure in at least (or only) the electric motor 34. For example, an efficiency of the electric motor 34 may decrease more than expected when there is an increase in:
▪ internal frictional losses within the electric motor 34;
▪ internal mechanical losses within the electric motor 34;
▪ core losses of the electric motor 34;
▪ windage losses within the electric motor 34;
▪ heat related resistance within the electric motor 34;
▪ etc.

The fault determined (if present) in the step 310 may also or alternatively be indicative of a failure in at least (or only) the motor controller 32. For example, an efficiency of the motor controller 32 may decrease more than expected when:
▪ there are deterioration of electrical connections;
▪ there is an increase in solid state switch losses;
▪ there is inadequate heat sinking;
▪ there are deterioration of heat sink connections;
▪ there are lower gate drive voltages;
▪ there are gate drive board component failures;
▪ etc.

While the step 310 is described above as determining the presence of a fault in the power system 24, the monitoring system 26 may also or alternatively predict a future fault in the power system 24. The system controller 74, for example, may compare the power system efficiency parameter to another threshold (e.g., a threshold efficiency parameter) using a similar or the same methodology as described above. In addition or alternatively, the monitoring system 26 and its system controller 74 may monitor and track the power system efficiency parameter over time to determine trends. These trends may be indicative of a deterioration of the power system 24 and, thus, a future potential fault in the power system 24.

In step 312, the monitoring system 26 may output a signal when a fault is present in the power system 24. The monitoring system 26, for example, may signal a user interface in a cockpit of the aircraft to present a fault notification. The monitoring system 26 may also or alternatively signal a communication device to send a fault signal to a remote aircraft monitoring station; e.g., a service hub. The monitoring system 26 may still also or alternatively record the presence of the fault in its memory 84, or another memory for later retrieval. Of course, such signal(s) and/or memory recording(s) may also be performed where a future fault is predicted. Note, by communicating the fault and/or the predicted fault to the remote aircraft monitoring station and/or recording presence of the fault and/or the predicted fault in the memory 84, information associated therewith may be accessed by maintenance personnel to facilitate (e.g., schedule) future aircraft propulsion system service, etc.

In some embodiments, the monitoring system 26 may also include another voltage sensor 88 and another current sensor 90 arranged with the motor controller 32. The controller voltage sensor 88 is configured to determine (e.g., measure) a voltage received by or output from the motor controller 32. The controller voltage sensor 88, for example, may determine a total voltage (a) received by the motor controller 32 from the electric power source 30 at the controller inputs 50 or (b) output from the motor controller 32 to the electric motor 34 at the controller outputs 54. Alternatively, the monitoring system 26 may include multiple controller voltage sensors, where each of these controller voltage sensors determines a voltage at a respective controller input 50 or controller output 54. Similarly, the controller current sensor 90 is configured to determine (e.g., measure) a current received by or output from the motor controller 32. The controller current sensor 90, for example, may determine a total current (a) received by the motor controller 32 from the electric power source 30 at the controller inputs 50 or (b) output from the motor controller 32 to the electric motor 34 at the controller outputs 54. Alternatively, the monitoring system 26 may include multiple controller current sensors, where each of these controller current sensors determines a current at a respective controller input 50 or controller output 54.

Using data from the controller voltage sensor 88 and the controller current sensor 90, the monitoring system 26 may determine a controller electrical power parameter. This controller electrical power parameter is indicative of an electric power drawn by the motor controller 32 or output from the motor controller 32. The controller electrical power parameter is thereby indicative of the total electrical power input into or output from the motor controller 32. The system controller 74, for example, may receive a voltage signal from the controller voltage sensor 88 and a current signal from the controller current sensor 90. The voltage signal is indicative of the voltage determined by the controller voltage sensor 88. The current signal is indicative of the current determined by the controller current sensor 90. The system controller 74 may then process data from the voltage signal with data from the current sensor to determine the controller electrical power parameter. More particularly, the system controller 74 may multiply the determined voltage by the determined current to determine the total electrical power input into or output from the motor controller 32.

Using the controller electrical power parameter, the monitoring system 26 may determine an efficiency of the power system 24 upstream of the electric motor 34. The system controller 74, for example, may compare the controller electrical power parameter with the electrical power output parameter to determine efficiency of the power system 24 upstream of the electric motor 34. More particularly, the system controller 74 may divide the controller electrical power parameter by the electrical power output parameter to determine the efficiency of the power system 24 upstream of the electric motor 34. This efficiency may then be used to determine presence of a fault in the power system 24 upstream of the electric motor 34 using a similar or the same methodology as described above in the step 310. A comparison between the electrical power output parameter and the controller electrical power parameter may also or alternatively be utilized to check accuracy of the power source voltage sensor 70 and/or the power source current sensor 71.

In addition or alternatively, the monitoring system 26 may determine an efficiency of the power system 24 downstream of the electric power source 30. The system controller 74, for example, may compare the mechanical power output parameter with the controller electrical power parameter to determine efficiency of the power system 24 downstream of the electric power source 30. More particularly, the system controller 74 may divide the mechanical power output parameter by the controller electrical power parameter to determine the efficiency of the power system 24 downstream of the electric power source 30. This efficiency may then be used to determine presence of a fault in the power system 24 downstream of the electric power source 30 using a similar or the same methodology as described above in the step 310.

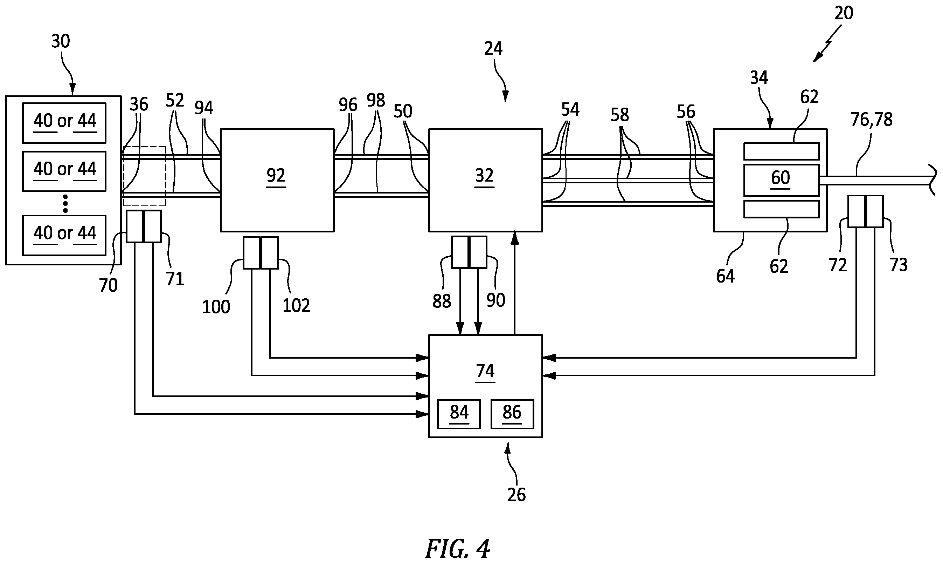

Referring to FIG. 4, the power system 24 may also include a power distribution system 92 between and electrically coupling the electric power source 30 and the motor controller 32. This power distribution system 92 of FIG. 4, for example, includes one or more electrical inputs 94 into the power distribution system 92; e.g., input terminals. Each of these distribution system inputs 94 is electrically coupled to a respective one of the power source outputs 36 through, for example, at least (or only) the respective electric power cable 52. The power distribution system 92 of FIG. 4 also include one or more electrical outputs 96 from the power distribution system 92; e.g., output terminals. Each of these distribution system outputs 96 is electrically coupled to a respective one of the motor inputs 56 through, for example, at least (or only) an electric power cable 98.

The power distribution system 92 is configured to distribute electricity drawn from the various units (e.g., 40 or 44) of the electric power source 30 to the motor controller 32. The power distribution system 92 may also be configured to selectively electrically couple the electric power source 30 to the motor controller 32. The motor controller 32 may be implemented using one or more electric elements. Examples of these electric elements include, but are not limited to, switches, contactors, relays, capacitors, resistors, bypass circuits, etc.

In some embodiments, the monitoring system 26 may also include another voltage sensor 100 and another current sensor 102 arranged with the power distribution system 92. The distribution system voltage sensor 100 is configured to determine (e.g., measure) a voltage received by or output from the power distribution system 92. The distribution system voltage sensor 100, for example, may determine a total voltage (a) received by the power distribution system 92 from the electric power source 30 at the distribution system inputs 94 or (b) output from the power distribution system 92 to the motor controller 32 at the distribution system outputs 96. Alternatively, the monitoring system 26 may include multiple distribution system voltage sensors, where each of these distribution system voltage sensors determines a voltage at a respective distribution system input 94 or distribution system output 96. Similarly, the distribution system current sensor 102 is configured to determine (e.g., measure) a current received by or output from the power distribution system 92. The distribution system current sensor 102, for example, may determine a total current (a) received by the power distribution system 92 from the electric power source 30 at the distribution system inputs 94 or (b) output from the power distribution system 92 to the motor controller 32 at the distribution system outputs 96. Alternatively, the monitoring system 26 may include multiple distribution system current sensors, where each of these distribution system current sensors determines a current at a respective distribution system input 94 or at a respective distribution system output 96.

Using data from the distribution system voltage sensor 100 and the distribution system current sensor 102, the monitoring system 26 may determine a distribution system electrical power parameter. This distribution system electrical power parameter is indicative of an electric power drawn by the power distribution system 92 or output from the power distribution system 92. The distribution system electrical power parameter is thereby indicative of the total electrical power input into or output from the power distribution system 92. The system controller 74, for example, may receive a voltage signal from the distribution system voltage sensor 100 and a current signal from the distribution system current sensor 102. The voltage signal is indicative of the voltage determined by the distribution system voltage sensor 100. The current signal is indicative of the current determined by the distribution system current sensor 102. The system controller 74 may then process data from the voltage signal with data from the current sensor to determine the distribution system electrical power parameter. More particularly, the system controller 74 may multiply the determined voltage by the determined current to determine the total electrical power input into or output from the power distribution system 92.

Using the distribution system electrical power parameter, the monitoring system 26 may determine an efficiency of the power system 24 upstream of the motor controller 32. The system controller 74, for example, may compare the distribution system electrical power parameter with the electrical power output parameter to determine efficiency of the power system 24 upstream of the motor controller 32. More particularly, the system controller 74 may divide the distribution system electrical power parameter by the electrical power output parameter to determine the efficiency of the power system 24 upstream of the motor controller 32. This efficiency may then be used to determine presence of a fault (and/or predict a fault) in the power system 24 upstream of the motor controller 32 using a similar or the same methodology as described above in the step 310. A comparison between the electrical power output parameter and the distribution system electrical power parameter may also or alternatively be utilized to check accuracy of the power source voltage sensor 70 and/or the power source current sensor 71.

In addition or alternatively, the monitoring system 26 may determine an efficiency of the power system 24 downstream of the electric power source 30 and upstream of the electric motor 34. The system controller 74, for example, may compare the distribution system electrical power parameter with the controller electrical power parameter to determine efficiency of the power system 24 downstream of the electric power source 30 and upstream of the electric motor 34. More particularly, the system controller 74 may divide the controller electrical power parameter by the distribution system electrical power parameter to determine the efficiency of the power system 24 downstream of the electric power source 30 and upstream of the electric motor 34. This efficiency may then be used to determine presence of a fault (and/or predict a fault) in the power system 24 downstream of the electric power source 30 and upstream of the electric motor 34 using a similar or the same methodology as described above in the step 310. A comparison between the controller electrical power parameter and the distribution system electrical power parameter may also or alternatively be utilized to check accuracy of (a) the distribution system voltage sensor 100 and/or the distribution system current sensor 102, or (b) the controller voltage sensor 88 and/or the controller current sensor 90.

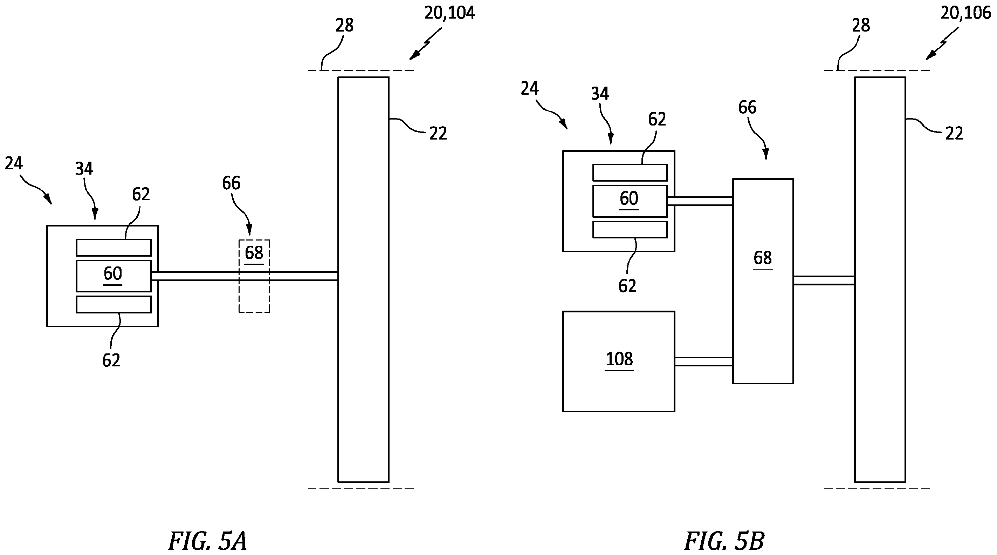

In some embodiments, referring to FIG. 5A, the aircraft propulsion system 20 may be configured as an electric propulsion system 104. The power system 24 of FIG. 5A, for example, is configured as a sole driver for driving rotation of the propulsor rotor 22. Of course, it is contemplated the aircraft propulsion system 20 may include multiple of the electric motors operatively coupled to the same propulsor rotor 22 through the drivetrain 66. In other embodiments, referring to FIG. 5B, the aircraft propulsion system 20 may be configured as a hybrid propulsion system 106. The aircraft propulsion system 20 of FIG. 5B, for example, also includes a heat engine 108 operatively coupled to the same propulsor rotor 22 through the drivetrain 66; e.g., through the geartrain 68. Here, the electric motor 34 and the heat engine 108 are arranged in parallel with the propulsor rotor 22 through the geartrain 68. The present disclosure, however, is not limited to such an exemplary arrangement. The electric motor 34 and the heat engine 108, for example, may alternatively be coupled to the propulsor rotor 22 in series. Examples of the heat engine 108 include, but are not limited to, a gas turbine engine, a reciprocating piston engine, a rotary engine (e.g., a Wankel engine), or another type of continuous or intermittent internal combustion engine.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An assembly for an aircraft, comprising:
a power system (24) including an electric power source (30), an electric motor (34) and a motor controller (32) electrically coupled between the electric power source (30) and the electric motor (34), the motor controller (32) configured to regulate a flow of electricity from the electric power source (30) to the electric motor (34), and the electric motor (34) configured to drive rotation of a rotating component (76); and
a monitoring system (26) configured to determine an electric power output parameter, a mechanical power output parameter and an efficiency parameter based on the electric power output parameter and the mechanical power output parameter, the electric power output parameter indicative of an electric power drawn by the electric motor (34) through the motor controller (32) from the electric power source (30), and the mechanical power output parameter indicative of a mechanical power received by the rotating component (76) from the electric motor (34).

2. The assembly of claim 1, wherein:
the monitoring system (26) includes a voltage sensor, a current sensor and a system controller (74);
the voltage sensor is configured to determine a voltage drawn by the electric motor (34) through the motor controller (32) from the electric power source (30);
the current sensor is configured to determine a current drawn by the electric motor (34) through the motor controller (32) from the electric power source (30); and
the system controller (74) is configured to determine the electric power output parameter based on the voltage and the current.

3. The assembly of claim 1 or 2, wherein:
the monitoring system (26) includes a speed sensor (72), a torque sensor (73) and a system controller (74);
the speed sensor (72) is configured to determine a speed that the rotating component (76) rotates about an axis;
the torque sensor (73) is configured to determine a torque received by the rotating component (76) from the electric motor (34); and
the system controller (74) is configured to determine the mechanical power output parameter based on the speed and the torque.

4. The assembly of claim 1, 2 or 3, the monitoring system (26) comprises a system controller (74) configured to control operation of the motor controller (32) to regulate the flow of electricity from the electric power source (30) to the electric motor (34).

5. The assembly of any preceding claim, wherein the efficiency parameter is determined by comparing the electric power output parameter and the mechanical power output parameter.

6. The assembly of any preceding claim, wherein the monitoring system (26) is further configured to compare the efficiency parameter to a threshold to determine presence of a fault in the power system (24),
wherein, optionally:
the fault is determined as being present when the efficiency parameter is below the threshold; and/or
the threshold is determined using artificial intelligence.

7. The assembly of claim 6, wherein:
the fault is indicative of a failure in the electric motor (34); and/or
the fault is indicative of a failure in the motor controller (32); and/or
the fault is indicative of a failure in the power system (24) upstream of the motor controller (32).

8. The assembly of any preceding claim, wherein the monitoring system (26) is further configured to compare the efficiency parameter to a threshold to predict a future fault in the power system (24).

9. The assembly of any preceding claim, wherein:
the monitoring system (26) is further configured to determine a controller electric power parameter and a second efficiency parameter;
the controller electric power parameter is indicative of an electric power input into or output from the motor controller (32); and
the second efficiency parameter is determined based on the controller electric power parameter and one of the electric power output parameter or the mechanical power output parameter.

10. The assembly of any preceding claim, wherein:
the power system (24) further includes a power distribution system (92) electrically coupling the electric power source (30) to the motor controller (32);
the monitoring system (26) is further configured to determine a distribution system electric power parameter and a second efficiency parameter;
the distribution system electric power parameter is indicative of an electric power input into or output from the power distribution system (92); and
the second efficiency parameter is determined based on the distribution system electric power parameter and the electric power output parameter.

11. The assembly of any preceding claim, wherein:
the power system (24) further includes a power distribution system (92) electrically coupling the electric power source (30) to the motor controller (32);
the monitoring system (26) is further configured to determine a controller electric power parameter, a distribution system electric power parameter and a second efficiency parameter;
the controller electric power parameter is indicative of an electric power input into or output from the motor controller (32);
the distribution system electric power parameter is indicative of an electric power input into or output from the power distribution system (92); and
the second efficiency parameter is determined based on the controller electric power parameter and the distribution system electric power parameter.

12. The assembly of any preceding claim, wherein the electric power source (30) comprises at least one of:
one or more battery cells; and/or
one or more fuel cells.

13. The assembly of any preceding claim, wherein:
the rotating component (76) comprises an output shaft (78) of the electric motor (34); and/or
the assembly further comprises a gear system coupled between an output shaft (78) of the electric motor (34) and the rotating component (76).

14. An assembly for an aircraft, comprising:
a propulsor rotor (22);
a power system (24) including an electric power source (30), an electric motor (34), a power distribution system (92) and a motor controller (32), the electric motor (34) configured to drive rotation of the propulsor rotor (22), the power distribution system (92) electrically coupling the electric power source (30) to the motor controller (32), the motor controller (32) electrically coupled between the power distribution system (92) and the electric motor (34), and the motor controller (32) configured to regulate a flow of electricity from the electric power source (30), through the power distribution system (92), to the electric motor (34); and
a monitoring system (26) configured to determine an electric power output parameter, a distribution system electric power parameter and an efficiency parameter based on the electric power output parameter and the distribution system electric power parameter, the electric power output parameter indicative of an electric power drawn by the electric motor (34) through the motor controller (32) and the power distribution system (92) from the electric power source (30), and the distribution system electric power parameter indicative of an electric power input into or output from the power distribution system (92).

15. An assembly for an aircraft, comprising:
a propulsor rotor (22);
a power system (24) including an electric power source (30), an electric motor (34), a power distribution system (92) and a motor controller (32), the electric motor (34) configured to drive rotation of the propulsor rotor (22), the power distribution system (92) electrically coupling the electric power source (30) to the motor controller (32), the motor controller (32) electrically coupled between the power distribution system (92) and the electric motor (34), and the motor controller (32) configured to regulate a flow of electricity from the electric power source (30), through the power distribution system (92), to the electric motor (34); and
a monitoring system (26) configured to determine a distribution system electric power parameter, a controller electric power parameter and an efficiency parameter based on the distribution system electric power parameter and the controller electric power parameter, the distribution system electric power parameter indicative of an electric power input into or output from the power distribution system (92), and the controller electric power parameter indicative of an electric power input into or output from the motor controller (32).
